(19) **Europäisches Patentamt / European Patent Office / Office européen des brevets**

(11) **EP 1 923 994 B1**

(12) **EUROPEAN PATENT SPECIFICATION**

(45) Date of publication and mention
of the grant of the patent:
**19.11.2008 Bulletin 2008/47**

(51) Int Cl.:
***H03G 7/00*** (2006.01)

(21) Application number: **06450169.5**

(22) Date of filing: **17.11.2006**

(54) **Audio compressor**

Audiokompressor

Compresseur audio

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**21.05.2008 Bulletin 2008/21**

(73) Proprietor: **AKG Acoustics GmbH**
**1230 Wien (AT)**

(72) Inventor: **Breitschädel, Hannes, Dipl.-Ing.**
**1170 Wien (AT)**

(74) Representative: **Patentanwälte**
**BARGER, PISO & PARTNER**
**Mahlerstrasse 9**
**1015 Wien (AT)**

(56) References cited:
**WO-A-99/00896**        **US-A- 5 434 922**
**US-A1- 2004 258 246**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The invention relates to an audio compressor with a detector for comparing an oncoming audio signal with a threshold, a gain generator, a release filter and an attack filter. Audio compressors are attenuators, which regulate their attenuation on their own as a function of the size of the input signal level. The level dependence is described by a static characteristic curve and the dynamic behavior of the compressor by the time dependence.

The term dynamic range is understood to mean the difference between the loudest and the quietest sound that can be produced or is produced by an acoustic source. For example, a CD has a dynamic range of 96 dB; the human voice up to 120 dB and a whole orchestra up to 140 dB. Audio compressors cause dynamic adaptation to a desired ideal standard.

For example, US 6,757,396 B1 reveals such an audio compressor, which is suitable for processing stereo signals and has a so-called "root mean square estimator" (RMS) for the input signal. A gain calculator calculates a gain for each arriving sample in the linear domain based on the preset parameters of which the static characteristics consist and as a function of the output of the RMS.

WO 99/00896 A discloses a hearing aid using an attack/release circuit and a variable gain amplifier. The gain of the variable gain amplifier is determined in dependence of two thresholds, the first threshold being compared to a signal taken before the variable gain amplifier, the second threshold being compared with a signal taken downstream of the variable gain amplifier. The input AGC (automatic gain control) signal and the output AGC signal are summed and the summed signal, processed through the attack/release circuit, is used to control the gain of the variable gain amplifier. The smoothing function is carried out by providing a capacitor in the attack/release circuit, and making the gain of the variable gain amplifier a function of the voltage across the capacitor. I.e., as the voltage across the capacitor increases, the gain of the variable gain amplifier decreases. The resistor is connected in series between the control circuit and the capacitor. The rate at which the capacitor charges (the so-called "attack time" of the attack/release circuit) is therefore determined by the RC time constant of the resistor and the capacitor. An additional resistor is placed across the capacitor. This creates a discharge path by which the capacitor may discharge through the resistor. The rate at which the capacitor discharges (the so-called "release time") is therefore determined by the RC time constant of the resistor.

An audio compressor constantly monitors the momentary input level and applies the necessary controls. The compressor only acts if the input level exceeds a certain threshold value, in that it attenuates the signal according to the compression conditions or ratio. It indicates by which amount the output level changes in relation to the input level. A compression ratio of 2:1 therefore means that the dynamic range at the input corresponds to double dynamic range at the output. For example, an input level change of 2 dB means an output level change of 1 dB.

The dependence between the input and the output level is represented by the static characteristic curve. It applies under static conditions, i.e. the volume of the input signal does not change or changes only very slowly. With a fast rise in level, it acts only after the so-called attack time, with a fast drop in level it acts only after the so-called release time.

The dynamic behavior of the compressor is thus determined by the adjustable parameters, attack and the release. The attack time determines the reaction time of the compressor to a certain extent. It is the adjustable time interval that elapses with a rise in the level after the threshold is exceeded, before the effect of the compressor, i.e. the attenuation, is initiated according to the static characteristic curve.

The release time defines that adjustable time interval that elapses with a drop in level below the threshold until the effect on the input signal in accordance with the static characteristic curve is initiated.

Some audio compressors are also equipped with a so-called knee controller with which it is possible to blend over between a hard and a soft attribute in several steps. If the attenuation of the compressor begins with the value of the ratio exactly at the threshold while, barely below the threshold, the signal is still transmitted with a ratio of 1:1, one speaks of a compressor with a hard knee. It has been determined that, in many cases, the sound is more pleasant if the transition from the 1:1 ratio to the set ratio in a certain domain about the threshold takes place softly. The characteristic curve transitions softly from the lower left into the upper right section - one therefore speaks of a soft knee. The knee parameter changes only the character of the compression but not its intensity.

If the compressor must decide whether the level has exceeded the threshold (or, with soft knee compression, how close the level has come to the threshold), it is, for example, possible to make use of the peak level or the RMS level. The latter corresponds more closely to the perceived volume.

The phenomenon called "pumping" by a compressor is understood to mean audible settings which are perceived by the ear as a breathing sound or in fact a pumping sound.

For example, pumping occurs when the peaks of the signal fall just below the threshold value without an additional (bass) sound and no or minimum compression takes place. If a bass sound then begins, which raises the signal level above the threshold, then not only the bass sound but inevitably the entire signal is attenuated. If the bass sound stops again, the signal is again amplified. When such a level is exceeded periodically, the listener gets impression of periodic attenuation of the entire signal - the music "pumps".

Pumping is particularly clearly audible if a compressor reacts dynamically to as statically perceived music signal (e.g. a calm sound background) by modifying the amplitude. control - artefacts are on the other hand hardly perceived if the compressor responds dynamically to a dynamic point in a piece of music (e.g. an accent).

Compressor pumping is disturbing or desirable depending on the application. For this reason there are, on the one hand, designs which try to suppress pumping if possible. On the other hand, there are designs where the pumping effect is popular and finds application e.g. as an artistic expression.

It is the objective of the present invention to create an audio compressor in order to make the pumping phenomenon generally manageable, in particular to provide the possibility of reducing or eliminating pumping.

This objective is achieved with an audio compressor as specified above by a feedback loop connecting the signal output of the audio compressor with the release filter, the feedback loop comprising a controller allowing at least one filter coefficient of the release filter to be modified depending on the output signal of audio compressor, whereby a modification of the effective release time occurs.

In a preferred embodiment the extent to which the effective release time is changed as a function of the deviation of the compressor output level from a threshold is adjustable by the user via an user interface connected to the feedback loop.

The invention comprises also an audio compression method using an audio compressor comprising a detector for comparing an incoming audio signal with a threshold, a gain generator connected to the detector and generating a gain for the audio signal in dependence of the output of the detector, a release filter applying a release time on the gain, when the level of the audio signal falls below the threshold and an attack filter, applying an attack time on the gain, when the level of the audio signal rises above the threshold. The above mentioned objectives are achieved by the fact that the effective release time is modified in dependence on the compressed signal of the audio compressor.

In a preferred embodiment the effective release time is increasing the closer the level at the compressor output converges to a preset threshold.

In a further preferred embodiment the extent to which the effective release time is changed as a function of the deviation of the level at the compressor output from the preset threshold is adjustable by the user.

In a further preferred embodiment an adjustable parameter is applied to the output signal level as a weighting factor and the change of the effective release time occurs depending on the ratio between the weighted signal output level and the preset threshold.

These computational operations are preferably designed in such a manner that the effective release time increases the closer the output signal or its magnitude converges to a threshold (e.g. the threshold of the compressor).

As mentioned above the aforesaid parameter is adjustable by the user of the compressor and it is possible to switch continuously between an operation in which the output signal has no effect on the release filter properties and an operation in which an increase in the output signal level causes a prolongation of the release time. The additional parameter is a measure to what an extent the release time changes as a function of the output signal or the deviation of the output signal from a threshold.

Both possibilities can be considered through a corresponding adjustment of what is subsequently called the freezer parameter in that, in cases in which pumping is not desired, it can be reduced or inhibited, while it can be left it as it is in cases in which it is not perceived to be disturbing.

In the following, the invention is described in greater detail by means of the drawings that show:

Fig. 1 a block diagram of a compressor of this invention,
Fig. 2 the static characteristic curve of an audio compressor,
Fig. 3 a possible design of an attack filter,
Fig. 4 a block diagram of an audio compressor of this invention in detail,
Fig. 5 the dependence of the filter coefficient of the release filter as a function of the absolute value of the output signal and of the additional parameter according to this invention,
Fig. 6 the behaviour of a filter coefficient in dependence of a time constant,
Fig. 7 an embodiment of an inventive audio compressor.

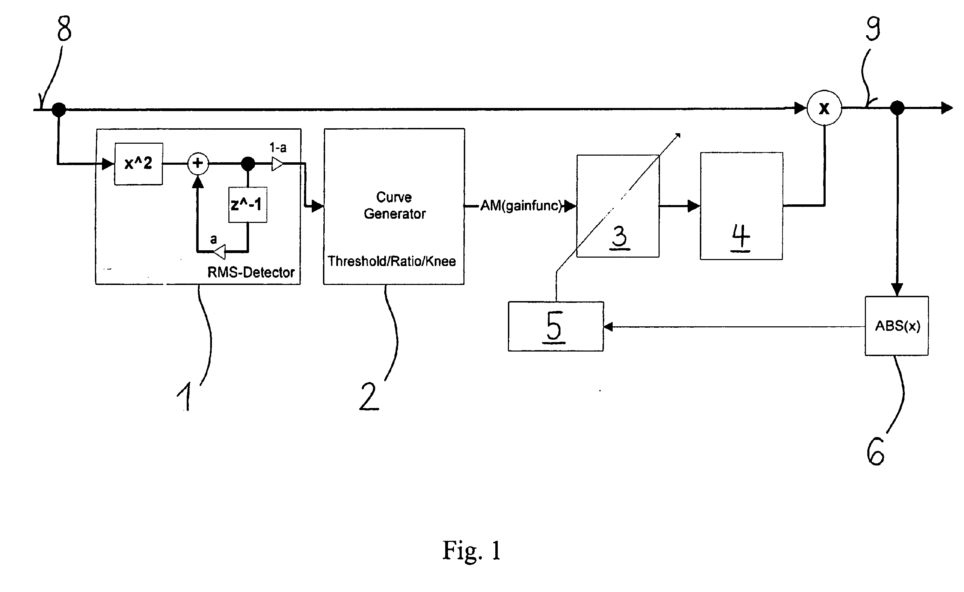

The possible embodiment shown in Figures 1 to 5 serves only to illustrate the invention, but does not thereby limit it. Thus, the mathematical operators and the filter designs discussed in greater detail below can be configured differently. The important item is the feedback loop, which interconnects the signal output with the release filter and which changes the filter coefficient(s) of the release filter depending on the output signal and preferably a user adjustable parameter, whereby the effective release time is changed.

The following briefly describes some areas of application of compressors: Compressors are for example used in recording studios for producing music in broadcasting facilities for purposes of adapting the audio material to the transmission circuit (reduction of dynamic range, optimal transmission). A broad pallet of very different devices is usually available, from which the sound technician selects the one which is most suitable for a certain purpose based on empirical data. This application offers the possibility of classifying the variety of devices: On one hand there are devices which are to implement dynamics processing as inaudibly as possible, i.e. to produce no pumping and control effects. On the other hand there are designs that are used exactly due to pumping and control effects and are consciously used to modify the audio material (increase in presence, production of an impressive sound). For example, a compressor operating inaudibly is used in the jazz and classical music field for adapting to a transmission channel (radio). A compressor with clearly audible control effects can be used for percussion in the Pop/Rock genre to produce an impressive, loud sound.

In one of its embodiments, the invention now offers the possibility of blending softly between these different compressor types by means of a new adjustable parameter. The advantage to the user resulting therefrom is a reduction in his instrumentation, cost savings and an increase in operating efficiency. The pumping behavior can now be controlled via this parameter in which the user can control by means of an interface such as a button, a knob, a keyboard or the like.

The invention is part of an audio compressor. The structure of this compressor is described in the introduction. Thereafter, how the application of a parameter for the pumping behavior functions and what advantages result therefrom are described.

The compressor can be implemented as a software algorithm with a digital signal processor. This is a feed forward structure, i.e. the calculation of the control function gain (amplitude modulation) derives from the input signal. The audio signals have to be transformed to or being available in the digital form.

Fig. 1 shows an overview of the signal flow. The input signal 8 is compared with a threshold in a detector 1. In the described example, the modulation function is determined via an RMS (root mean square) measurement 1, followed by characteristic curve calculations in a gain generator 2, followed by the timing components, the release filter 3 and the attack filter 4.

The input signal 8 is first transmitted to a step for measuring the RMS (root mean square) value. A measurement of the absolute value, the peak value, the rectification value, etc. is also naturally conceivable. Such level measurements are well known to the specialist. However, the RMS value is preferred because it corresponds well to the perceived volume and one thereby achieves control that is adapted to the ear.

A standardized process with squaring of the samples and subsequent filtering with a recursive first order low-pass filter and a typical time constant of, for example, about 50 ms is used.

It is possible to proceed without the calculation of the square root in this step if the signal is converted to the logarithm in the subsequent gain generator 2 (curve generator) and the square root is calculated in the logarithmic domain by dividing by 2. It is of course possible to also stay in the linear domain, similar to what is described in US 6,757,396 B1.

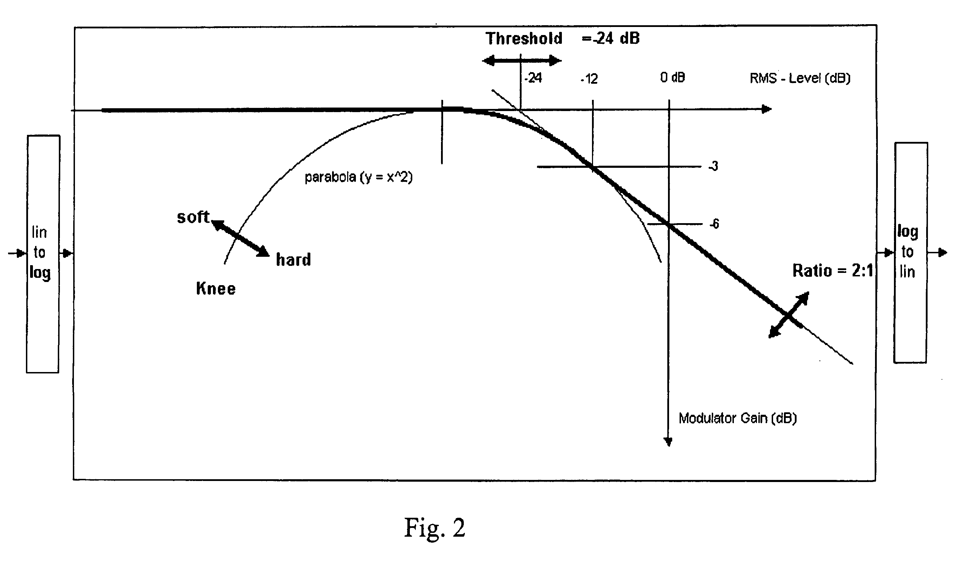

The gain generator 2, whose possible characteristic curve is shown in Fig. 2, applies the static characteristic curve as a function of the parameter threshold, the ratio and the knee. The figure shows an example with a ratio of 2:1 and a threshold of -24 dB.

The output of the gain generator 2 already contains the modulation function, which is now also transmitted through two filters 3, 4 for purposes of applying the settable time response. The output of the attack filter 4 is now applied to the input signal, which is to be compressed by being multiplied by the latter.

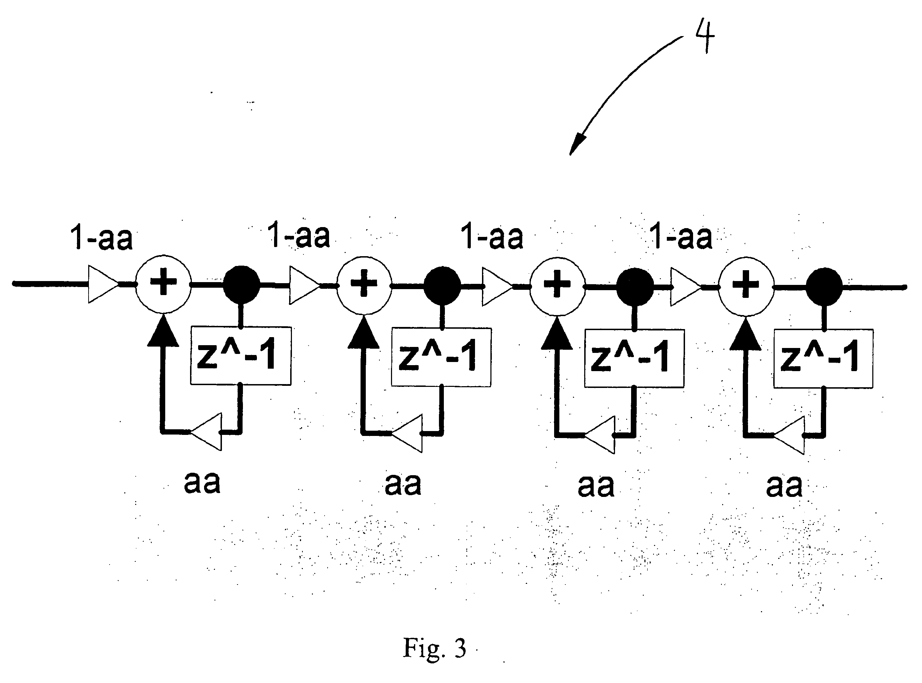

The attack filter 4 can for example - as shown in Fig. 3 - be designed as a low-pass filter of the 4th order with settable time constants of 1 ms to 500 ms. It is active when the modulation function has falling values (a negative first derivative), i.e. the level at the compressor input rises above the threshold (attack phase). However, the release filter 3 acts when the level at the input of the compressor drops again.

Pumping of a compressor is understood to imply audible controls, which are perceived by the ear as breathing or in fact pumping. Pumping is particularly clearly audible if a compressor reacts dynamically to a statically perceived music signal (e.g. a calm sound background) with a modification in amplitude. On the other hand, control artefacts are hardly perceived if a dynamic part of a piece of music (e.g. an accent) is acted upon with dynamic control.

Compressor pumping is disturbing or desired depending on the application. For this reason there are, on the one hand, designs that try to suppress pumping as much as possible. On the other hand, there are designs where the pumping effect is very much desired and e.g. is used as a means of artistic expression. It is then an object of this invention to achieve a blend between these different designs, whereby a universally applicable compressor is obtained.

In the present particularly preferred embodiment, this is achieved by controlling the release behavior by the new parameter PF. In this case, the release time is changed as a function of the parametric setting of the compressor output signal. Thereby, unwanted pumping effects can be eliminated.

First, an attempt is made to achieve a classification of the audio signal between "static" and "dynamic" at the output of the compressor and to slow the compressor down or to "freeze" its temporal response in the case of static signals.

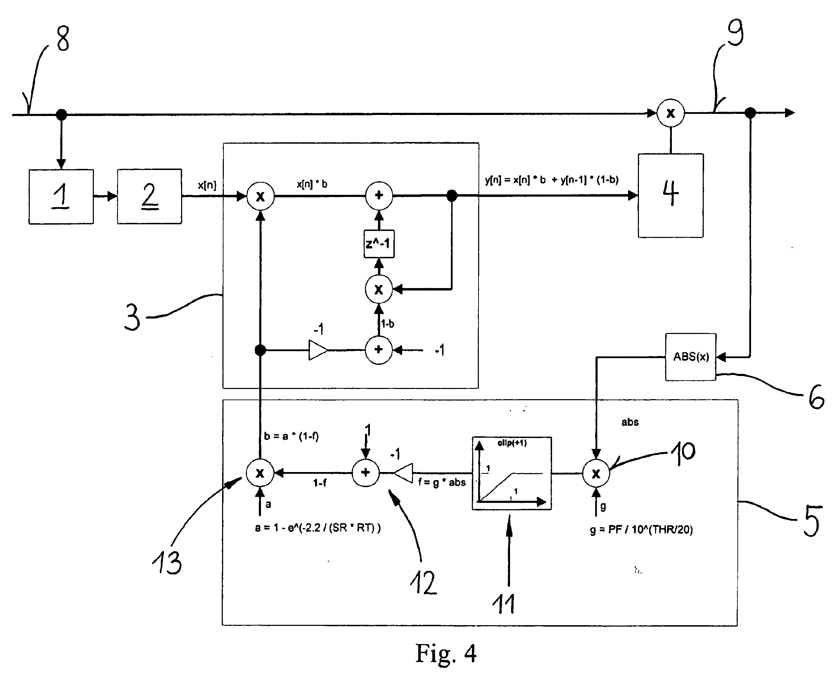

Fig. 4 shows in detail how a possible technical conversion functions. The release filter 3 is configured as a digital low-pass filter of the first order with the coefficient b. The effect on the samples x[n] originating from gain generator is given by

$$y[n] = x[n] * b + y[n-1] * (1-b).$$

b is calculated adaptively from the output signal of the compressor. The parameter for these calculations is a set release time value and a parameter PF, in the following also called the freezing value or freezer value.

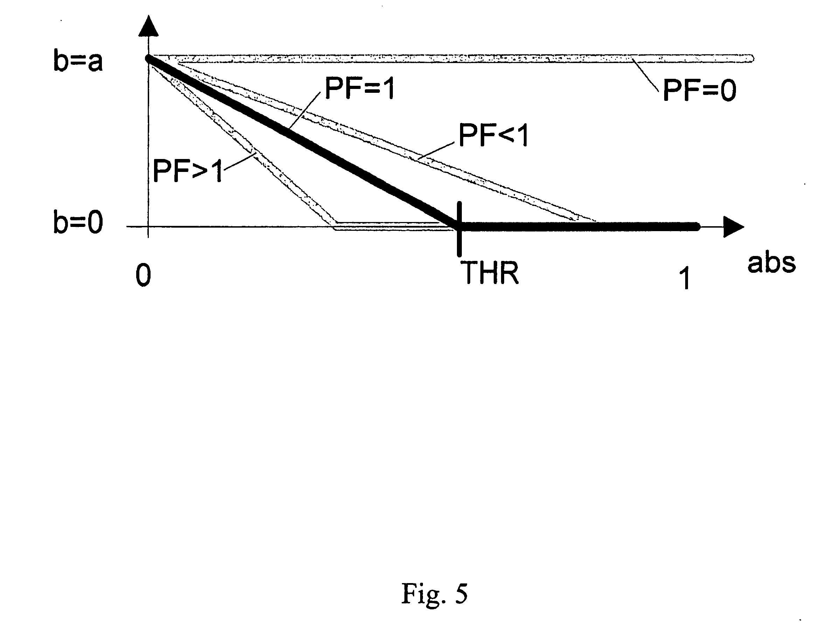

Fig. 5 elucidates the effect of this parameter PF. a denotes to the static filter coefficient, which is adjusted by the user, b is the adapted filter coefficient, abs is the absolute value of the compressor output signal 9 and thr the threshold value recalculated in the linear domain. If the freezer parameter is set to zero (PF = 0), then a preset release time, according to the static filter coefficient a, is always valid and there is no change as a function of the compressor output signal. If the parameter PF is raised, an ever stronger dependence exists, such that the release time is increased, i.e. the release behavior slows down, in proportion to how close the level at the compressor output approaches the threshold. The limit is achieved when the coefficient b reaches the value zero, which corresponds to full freezing or to an infinite release time. The effect of an increasing release time occurs in the case, when the compressed signal 9 also increases. As seen from Fig. 5 it is also possible with an appropriate parametrisation (PF < 1), that the release time further increases in the region above the threshold thr and becomes infinity at levels higher than the threshold. The parameter PF of the present example can be understood as a weighting parameter applied to the compressed output signal 9. The release time is then modified in dependence of the weighted output signal.

Signal levels at the compressor output 9, which lie below the threshold, produce faster release behavior, signals near the threshold and above it a slower one.

In the following, the technical implementation is described in detail. The formation of the absolute value of the compressor output signal 9 takes place first in an unit 6. In the controller 5 (Fig. 4) the absolute value abs is now multiplied (by an operator 10) with the value g, which is

$$g = PF/10^{\wedge}(THR/20)$$

THR signifies the threshold in dB.

The clipper 11 represented by the small box labelled clip(+1) limits the input signal to a value of +1. This means that values smaller than 1 are allowed to pass through unhindered, while input values greater than 1 always result in output values of 1.

f = g * abs therefore represents the relation between the absolute value of the output signal and the threshold multiplied by the parameter PF. As a further consequence, the filter parameter b of the release filter 3 is obtained by means of the following arithmetic operations 12, 13:

$$b = a * (1-f),$$

where

$$a = 1 - exp(-2.2/(SR * RT))$$

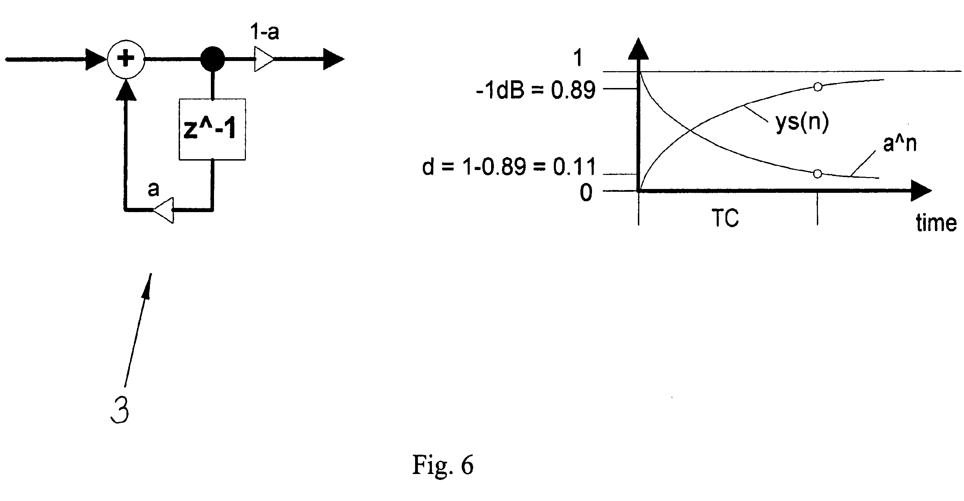

This formulation of the filter coefficients only represents any preferred example, which was selected on the basis the following considerations as represented in Fig. 6:

The step response of the filter 3 (left part of Fig. 6) is an exponential function (right part of Fig. 6):

$$ys(n) = 1 - a^{n}$$

where

ys(n) is the step response of the filter
n = TC*SR
TC is the time constant [s]
SR is the sampling rate [Hz]

The calculated parameter is the filter coefficient a, which produces an exponential function, which reaches the value d after the time TC. A transformation $d = a^{n}$ gives:

$$a = exp(ln(d) / ( TC*SR))$$

d is now selected so that the step function has shifted to -1 dB after the time TC.

$$ln(d) = ln(0.11) = -2.2$$

Therefore, in the present example, the filter coefficient

$$a = 1 - exp(-2.2/(SR * TC))$$

is selected, with the sample rate SR in Hertz (Hz) and the time constant TC in seconds (s). For the release filter the time constant TC is selected to equal the release time constant RT; in the following, a is also called the static filter coefficient. When the parameter PF is equal to zero (PF = 0, f = 0), the static filter coefficient is taken over unchanged by the release filter (b = a). The preset release time RT then determines the dynamic behavior of the compressor when the signal falls below the threshold.

When the value of PF = 1, the ratio between the absolute value abs of the compressor output signal 9 and the threshold thr (where thr now signifies the threshold recalculated for the linear domain) determines the value of the release filter coefficient b, which is also called the adapted filter coefficient in the following. If the ratio is 1, i.e. the value abs reaches the threshold, the value $b = 0$ is obtained based on to the aforementioned computational specifications. This corresponds to an infinitely long release time and means that the gain value of the characteristic curve of the generator which is active via the output signal at the point in time when the threshold is reached is frozen until the output signal has again fallen below the threshold.

For PF values greater than or smaller than 1, Fig. 5 shows the dependence of the adapted filter coefficient b on the absolute value abs at the compressor output. Different steps can now be inserted depending on the desired dynamic characteristics within the region near the threshold of the output signal. For example, the freezing for PF 0.1 only takes place for signals above the threshold, while, for PF > 1, freezing already occurs before the thresholds is reached.

For the dynamics of the compressor this means that, with increasing approximation of the absolute value of the output signal against the threshold, the release time will be increased.

By means of a corresponding adjustment of the release time value, the so-called static release time RT, that is the release time with PF = 0, and by setting the freezer parameter PF, the dynamics of the compressor can be configured as desired, particularly the pumping phenomenon can be controlled in an elegant manner via the mode of action of this invention. Where it is not desired, the parameter PF is selected so that the value of b in close proximity to the threshold thr assumes the value zero while, with the desired application of "pumping" as an artistic element, a value of PF = 0 or slightly higher is selected.

This invention is not limited to the described embodiment. The computational operations proposed above and the dependences of the various parameters on the output signal of the compressor represent a preferred implementation, but different approaches are possible in principle.

Thus, for example, the threshold of the gain generator 2 and the threshold with which the output signal 9 is compared or rationed can be of different magnitudes. Other filter structures can also be used for the release filter 3 (and the attack filter 4), for example filters of a higher order, several filter parameters as well as with other parameters. Basically, any set of parameters which in effect produces a change of the effective release time as a function of the output signal and a user adjustable parameter is usable.

For certain applications, negative values of PF could also be meaningful. The behavior of the controller 5 would then be reversed: for signals near the threshold, the release time would be shortened.

It is an main idea of an embodiment of this invention to provide a conventional compressor with a new parameter that is accessible to the user, which first of all allows the pumping behavior to become a controlled parameter. The solution presented here is one possibility regarding how this behavior can be achieved. Due to the presence of a parameter for adjusting the pumping behavior that is accessible to the user, the compressor of this invention can be designated as providing a little to a lot of pumping.

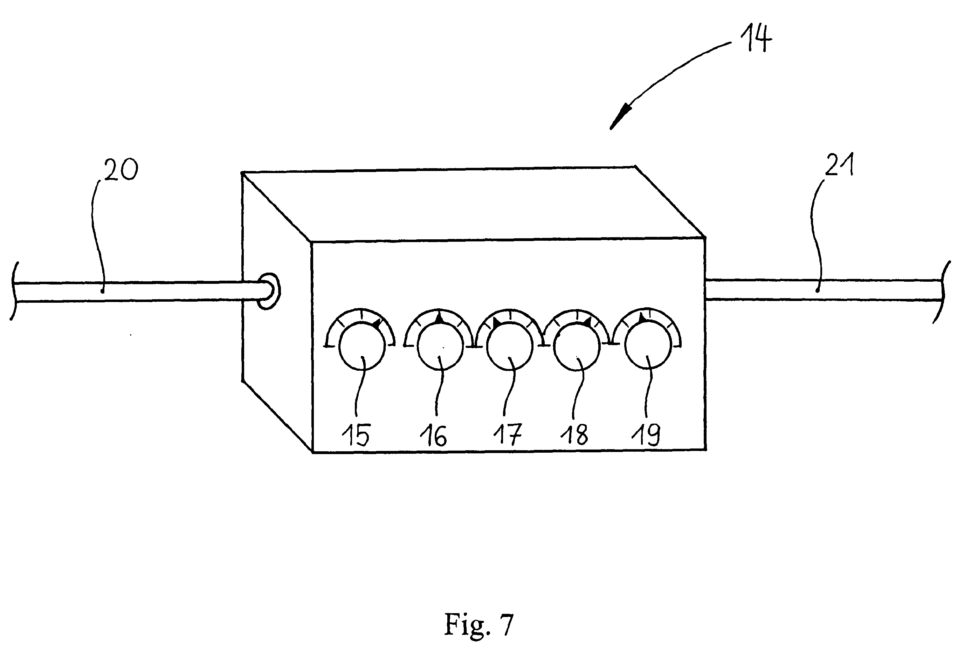

A compressor of this invention can be integrated in all possible audio devices, such as microphones, mixers, recording and play-back devices, loudspeakers and the like, or - as shown in Fig. 7 - it can be designed as an independent device with an input and an output. The user interface then includes input devices, such as a keyboard or dials, in order to set the various parameters. In a preferred embodiment, in addition to include the threshold, ratio, release time, attack time, the user interface may also include the knee as well as the possibility of adjusting the freezer parameter PF described above. The adjustable release time value then only corresponds with the actually operative or effective release time if PF = 0 or there is no dependence on the output signal.

The audio compressor 14 as shown in Fig. 7 is connected to an audio input line 20 and an audio output line 21 comprises several rotary knobs on the front panel. Knobs 15, 16, 17 and 18 permit the adjustment of the parameters threshold, ratio, static release time and attack time. The additional knob 19 relates to the parameter PF, which allows to make the effective release time dependent on the compressor output signal. The static release time has its validity only if the feedback loop is abrogated (parameter PF is set equal to zero). In all other cases the value of the release time is changed in dependence of the output signal. Instead of knobs any other kind of user interface can be used, in order to activate the feedback loop connecting release filter 3 with the compressor output line 9 and to adjust the influence of output signal on the release time change.

## Claims

1. Audio compressor with a detector (1) for comparing an incoming audio signal with a threshold, a gain generator (2), a release filter (3) and an attack filter (4), **characterized by** a feedback loop connecting the signal output (9) of the audio compressor (14) with the release filter (3), the feedback loop comprising a controller (5) allowing at least one filter coefficient (b) of the release filter (3) to be modified depending on the output signal (9) of audio compressor (14), whereby a modification of the effective release time occurs.

2. Audio compressor according to Claim 1, **characterized by** the fact that the extent to which the effective release time is changed as a function of the deviation of the compressor output level from a threshold is adjustable by the user via an user interface (19) connected to the feedback loop.

3. Audio compression method using an audio compressor comprising a detector (1) for comparing an incoming audio signal with a threshold, a gain generator (2) connected to the detector (1) and generating a gain for the audio signal in dependence of the output of the detector (1), a release filter (3) applying a release time on the gain, when the level of the audio signal falls below the threshold and an attack filter (4), applying an attack time on the gain, when the level of the audio signal rises above the threshold, **characterized by** the fact that the effective release time is modified in dependence on the compressed signal (9) of the audio compressor (14).

4. Audio compression method according to Claim 3, **characterized by** the fact that the effective release time is increasing the closer the level at the compressor output converges to a preset threshold.

5. Audio compression method according to one of the Claims 3 or 4, **characterized by** the fact that the extent to which the effective release time is changed as a function of the deviation of the level at the compressor output from the preset threshold is adjustable by the user.

6. Audio compression method according to Claim 3, **characterized by** the fact that an adjustable parameter (PF) is applied to the output signal level as a weighting factor and the change of the effective release time occurs depending on the ratio between the weighted signal output level and the preset threshold.

**Patentansprüche**

1. Audiokompressor mit einem Detektor (1) zum Vergleich eines eingehenden Audiosignals mit einem Threshold, einem Gain Generator (2), einem Release-Filter (3) und einem Attack-Filter (4), **gekennzeichnet durch** eine Feedbackschleife, die den Signalausgang (9) des Audiokompressors (14) mit dem Release-Filter (3) verbindet, wobei die Feedbackschleife einen Controller (5) umfasst, der das Modifizieren mindestens eines Filterkoeffizienten (b) des Release-Filters (3) in Abhängigkeit des Ausgangssignals (9) des Audiokompressors (14) ermöglicht, wobei eine Veränderung der effektiven Releasezeit erfolgt.

2. Audiokompressor nach Anspruch 1, **dadurch gekennzeichnet, dass** das Maß, mit dem die effektive Releasezeit als Funktion der Abweichung des Kompressorausgangspegels von einem Threshold geändert wird, vom Benutzer über eine mit der Feedbackschleife verbundene Benutzerschnittstelle (19) einstellbar ist.

3. Audiokompressionsverfahren, bei dem ein Audiokompressor verwendet wird, der einen Detektor (1) zum Vergleich eines eingehenden Audiosignals mit einem Threshold, einen Gain Generator (2), der mit dem Detektor (1) verbunden ist und eine Gain für das Audiosignal in Abhängigkeit des Ausgangs des Detektors (1) generiert, ein Release-Filter (3), das eine Releasezeit auf die Gain anwendet, wenn der Pegel des Audiosignals unter den Threshold fällt, und ein Attack-Filter (4), das eine Attackzeit auf die Gain anwendet, wenn der Pegel des Audiosignals über den Threshold steigt, umfasst, **dadurch gekennzeichnet, dass** die effektive Releasezeit in Abhängigkeit des komprimierten Signals (9) des Audiokompressors (14) modifiziert wird.

4. Audiokompressionsverfahren nach Anspruch 3, **dadurch gekennzeichnet, dass** die effektive Releasezeit erhöht wird, je mehr sich der Pegel am Kompressorausgang einem voreingestellten Threshold nähert.

5. Audiokompressionsverfahren nach einem der Ansprüche 3 oder 4, **dadurch gekennzeichnet, dass** das Maß, mit dem die effektive Releasezeit als Funktion der Abweichung des Pegels am Kompressorausgang vom voreingestellten Threshold geändert wird, vom Benutzer einstellbar ist.

6. Audiokompressionsverfahren nach Anspruch 3, **dadurch gekennzeichnet, dass** ein einstellbarer Parameter (PF) als Gewichtungsfaktor auf den Ausgangssignalpegel angewandt wird und die Änderung der effektiven Releasezeit in Abhängigkeit des Verhältnisses zwischen dem gewichteten Ausgangssignalpegel und dem voreingestellten Threshold erfolgt.

**Revendications**

1. Compresseur audio comportant un détecteur (1) pour comparer un signal audio entrant avec un seuil, un générateur de gain (2), un filtre d'extinction (3) et un filtre d'attaque (4), **caractérisé par** une boucle d'asservissement reliant la sortie de signal (9) du compresseur audio (14) au filtre d'extinction (3), la boucle d'asservissement comprenant un contrôleur (5) permettant de modifier au moins un coefficient de filtrage (b) du filtre d'extinction (3) en fonction du signal de sortie (9) du compresseur audio (14) causant l'apparition d'une modification du temps effectif d'extinction.

2. Compresseur audio selon la revendication 1, **caractérisé par le fait que** l'étendue de la modification du temps effectif d'extinction en fonction de l'écart du niveau de la sortie du compresseur par rapport à un seuil peut être ajustée par l'utilisateur par l'intermédiaire d'une interface utilisateur (19) reliée à la boucle d'asservissement.

3. Procédé de compression audio utilisant un compresseur audio comportant un détecteur (1) pour comparer un signal audio entrant avec un seuil, un générateur de gain (2) relié au détecteur (1) et générant un gain pour le signal audio en fonction de la sortie du détecteur (1), un filtre d'extinction (3) appliquant un temps d'extinction au gain lorsque le niveau du signal audio tombe en dessous du seuil, et un filtre d'attaque (4) appliquant un temps d'attaque au gain lorsque le niveau du signal audio monte au-dessus du seuil, **caractérisé par le fait que** le temps effectif d'extinction est modifié en fonction du signal comprimé (9) du compresseur audio (14).

4. Procédé de compression audio selon la revendication 3, **caractérisé par le fait que** le temps effectif d'extinction augmente plus le niveau à la sortie du compresseur converge vers un seuil prédéterminé.

5. Procédé de compression audio selon l'une des revendications 3 ou 4, **caractérisé par le fait que** l'étendue de la modification du temps effectif d'extinction en fonction de l'écart du niveau à la sortie du compresseur par rapport au seuil prédéterminé peut être ajustée par l'utilisateur.

6. Procédé de compression audio selon la revendication 3, **caractérisé par le fait qu'**un paramètre (PF) ajustable est appliqué au niveau de signal de sortie en tant que facteur de pondération et que la modification du temps effectif d'extinction se produit en fonction de la relation entre le niveau de sortie du signal pondéré et le seuil prédéterminé.

Fig. 1

EP 1 923 994 B1

Fig. 2

Fig. 3

EP 1 923 994 B1

EP 1 923 994 B1

8     9

1    2    x[n]

x[n] * b

$y[n] = x[n] * b + y[n-1] * (1-b)$

4

3

z^-1

1-b

-1

ABS(x)

6

abs

$b = a * (1-f)$

clip(+1)

10

1-f

$f = g * abs$

g

13

a

$a = 1 - e^{(-2.2 / (SR * RT))}$

12

11

$g = PF / 10^{(THR/20)}$

5

Fig. 4

Fig. 5

EP 1 923 994 B1

Fig. 6

EP 1 923 994 B1

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6757396 B1
- WO 9900896 A